(19) Europäisches Patentamt
European Patent Office
Office européen des brevets

(11) **EP 4 488 698 A1**

(12) **EUROPEAN PATENT APPLICATION**

(43) Date of publication:
**08.01.2025 Bulletin 2025/02**

(21) Application number: **23306162.1**

(22) Date of filing: **07.07.2023**

(51) International Patent Classification (IPC):
***G01R 31/3835*** (2019.01)   ***G01R 31/396*** (2019.01)
***G01R 35/00*** (2006.01)

(52) Cooperative Patent Classification (CPC):
**G01R 31/3835; G01R 31/396; G01R 35/005**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **NXP USA, Inc.**
**Austin TX 78735 (US)**

(72) Inventors:
• **Mallard,, Thomas**
**31023 Toulouse (FR)**
• **Cassagnes,, Thierry Dominique Yves**
**31023 Toulouse (FR)**
• **Tico,, Oliver**
**31023 Toulouse (FR)**

(74) Representative: **Schmütz, Christian Klaus Johannes**
**NXP Semiconductors Germany GmbH**
**Intellectual Property Group**
**Beiersdorfstr. 12**
**22529 Hamburg (DE)**

(54) **A BATTERY MANAGEMENT SYSTEM**

(57)   A battery management system comprising: a sequence of four or more battery connection terminals for connecting to a series of batteries; a resistance associated with each battery connection terminal; and a sequence of three or more ADCs. Each ADC is associated with a pair of the battery connection terminals and is configured to convert the difference between the analogue voltages at its first and the second ADC input terminals to a digital signal, and to provide that digital signal at its ADC output terminal. The battery management system also includes a digital processor that is configured to, for each ADC in the sequence: calculate an error voltage for the ADC based on: i) the digital signal for the preceding ADC in the sequence if there is one; and ii) the digital signal for the next ADC in the sequence if there is one; and provide a measured-voltage output signal by subtracting the error voltage from the digital signal for the ADC.

FIG. 2

**Description**

**Field**

The present disclosure relates to battery management systems.

**Summary**

According to a first aspect of the present disclosure there is provided a battery management system comprising:

a sequence of four or more battery connection terminals for connecting to a series of batteries such that each battery is connected between a pair of the battery connection terminals, wherein:

a first battery connection terminal is for connecting to a terminal of a battery at one end of the series of batteries;
a last battery connection terminal is for connecting to a terminal of a battery at the other end of the series of batteries; and
each other battery connection terminal is for connecting to a node in between two of the batteries in the series;

a resistance associated with each battery connection terminal;
a sequence of three or more ADCs, each associated with a pair of the battery connection terminals, each ADC having:

a first ADC input terminal, which is connected to one of the pair of battery connection terminals via its associated resistance;
a second ADC input terminal, which is connected to the other of the pair of battery connection terminals via its associated resistance; and
an ADC output terminal;

wherein:
each ADC is configured to convert the difference between the analogue voltages at its first and the second ADC input terminals to a digital signal, and to provide that digital signal at its ADC output terminal; and
a digital processor configured to, for each ADC in the sequence:

calculate an error voltage for the ADC based on: i) the digital signal for the preceding ADC in the sequence if there is one; and ii) the digital signal for the next ADC in the sequence if there is one; and
provide a measured-voltage output signal by subtracting the error voltage from the digital signal for the ADC.

Advantageously, using a digital processor to perform compensation in the digital domain can result in a lower current consumption, smaller die size, and can be readily scalable from one technology to another.

In one or more embodiments, the digital processor is further configured to, for each ADC in the sequence, calculate the error voltage also based on: iii) the digital signal for the ADC.

In one or more embodiments, the digital processor is configured to, for each intermediate ADC in the sequence, calculate the error voltage by applying the following formula:

$$\text{error voltage} = K \times (V_{n+1} + V_{n-1} - 2.V_n)$$

where:

K is a timing value;
$V_{n+1}$ is the value of the digital signal for the next ADC in the sequence, if there is one;
$V_{n-1}$ is the value of the digital signal for the preceding ADC in the sequence, if there is one; and
$V_n$ is the value of the digital signal for the ADC.

In one or more embodiments, the digital processor is configured to, for the first ADC in the sequence, calculate the error voltage by applying the following formula:

$$\text{error voltage} = K \times (V_{n+1} - V_n)$$

where:

K is a timing value;
$V_{n+1}$ is the value of the digital signal for the next ADC in the sequence; and
$V_n$ is the value of the digital signal for the first ADC.

In one or more embodiments, the digital processor is configured to, for the last ADC in the sequence, calculate the error voltage by applying the following formula:

$$\text{error voltage} = K \times (V_{n-1} - V_n)$$

where:

K is a timing value;
$V_{n-1}$ is the value of the digital signal for the preceding ADC in the sequence; and
$V_n$ is the value of the digital signal for the last ADC.

In one or more embodiments:

$$K = 2.R.f_{clk}.C_{in};$$

R is the resistance value of the resistance associated with each battery connection terminal;
$C_{in}$ is the capacitance of a capacitor at each input terminal of each of the ADC; and
$f_{clk}$ is the frequency of a clock associated with each ADC.

In one or more embodiments, the digital processor is configured to, for each ADC in the sequence, calculate the error voltage for the ADC by:

comparing the digital signal for the preceding ADC in the sequence, if there is one, with a threshold value in order to generate a preceding-ADC-in-use-signal;
comparing the digital signal for the next ADC in the sequence, if there is one, with a threshold value in order to generate a next-ADC-in-use-signal;
combining the preceding-ADC-in-use-signal and the next-ADC-in-use-signal in order to determine an error-multiplier; and
multiplying the error-multiplier by a predetermined voltage value.

In one or more embodiments, the predetermined voltage value is the expected voltage value of one of the batteries.

In one or more embodiments, the digital processor is further configured to, for each ADC in the sequence, calculate the error voltage for the ADC by:

comparing the digital signal for the ADC with a threshold value in order to generate an ADC-in-use-signal; and
combining the preceding-ADC-in-use-signal, the next-ADC-in-use-error-signal and the ADC-in-use-signal in order to determine the error-multiplier.

In one or more embodiments, the digital processor is further configured to, for each intermediate ADC:
combine the preceding-ADC-in-use-signal, the next-ADC-in-use-error-signal and the ADC-in-use-signal in order to determine the error-multiplier according to the following equation:

$$\text{error-multiplier} = \text{preceding-ADC-in-use-signal} + \text{next-ADC-in-use-error-signal} - 2 \times \text{ADC-in-use-signal}.$$

In one or more embodiments, the digital processor is further configured to, for the first and last ADC in the sequence:
combine the preceding-ADC-in-use-signal, the next-ADC-in-use-error-signal and the ADC-in-use-signal in order to determine the error-multiplier according to the following equation:

error-multiplier = preceding-ADC-in-use-signal + next-ADC-in-use-error-signal – ADC-in-use-signal.

In one or more embodiments, the digital processor is further configured to, for each ADC in the sequence, calculate the error voltage for the ADC by multiplying the error-multiplier and the predetermined voltage value by a timing value, K, wherein:

$$K = 2.R.f_{clk}.C_{in};$$

R is the resistance value of the resistance associated with each battery connection terminal;
$C_{in}$ is the capacitance of a capacitor at each input terminal of each of the ADC; and
$f_{clk}$ is the frequency of a clock associated with each ADC.

In one or more embodiments, the digital processor is further configured to:

apply a gain-correction voltage and / or an offset-correction voltage to each digital signal of the sequence of ADCs to provide a respective plurality of corrected digital signals; and
perform all subsequent processing on the corrected digital signals instead of the digital signals.

In one or more embodiments, the digital processor is configured to multiply each digital signal by the gain-correction voltage.

In one or more embodiments, the digital processor is configured to subtract the offset-correction voltage from each digital signal.

In one or more embodiments, the battery management system is configured to perform a calibration routine to determine the values for the gain-correction voltage and / or the offset-correction voltage.

In one or more embodiments, the battery management system is configured to perform the calibration routine by:

setting the voltage difference between each successive pair of battery connection terminals in the sequence to a first calibration value, and recording the measured-voltage output signal for each ADC as a first calibration output value;
setting the voltage difference between each successive pair of battery connection terminals in the sequence to a second calibration input value, and recording the measured-voltage output signal for each ADC as a second calibration output value; and
determining the values for the gain-correction voltage and / or the offset-correction voltage for each ADC based on: the first calibration value, the second calibration value, the first calibration output value associated with the ADC, and the second calibration output value associated with the ADC.

In one or more embodiments, determining the values for the gain-correction voltage and / or the offset-correction voltage comprises solving the following simultaneous equations for each ADC:

$$V_{meas1} = \gamma_{channel}.V_{X1} + o_{channel}$$

$$V_{meas2} = \gamma_{channel}.V_{X2} + o_{channel}$$

wherein:

$V_{X1}$ is the first calibration value;
$V_{X2}$ is the second calibration value;
Vmeas1 is the first calibration output value;
Vmeas2 is the second calibration output value;
$\gamma\_channel$ is the gain-correction voltage; and
*o_channel* is the offset-correction voltage.

In one or more embodiments, the battery management system is configured to perform the calibration routine by determining the value for the timing value, K, by:

setting the voltage difference between each successive pair of battery connection terminals in the sequence to a first calibration value, and recording the measured-voltage output signal for each ADC as a first calibration output value;

setting the voltage difference between each successive pair of battery connection terminals in the sequence to a second calibration input value, and recording the measured-voltage output signal for each ADC as a second calibration output value;

setting the voltage difference between an intermediate pair of battery connection terminals in the sequence to zero and at the same time setting the voltage difference between the adjacent pairs of battery connection terminals in the sequence to first calibration value, and recording the measured-voltage output signal for the ADC associated with the intermediate pair of battery connection terminals as a third calibration output value; and

determining the values for the gain-correction voltage and the offset-correction voltage using the following equation:

$$K = \frac{V_{X2}.V_{meas1} - V_{X1}.V_{meas2} - (V_{X2} - V_{X1}).V_{meas3}}{2.V_{X1}.(V_{X2} - V_{X1})}$$

wherein:

$V_{X1}$ is the first calibration value;
$V_{X2}$ is the second calibration value;
Vmeas1 is the first calibration output value;
Vmeas2 is the second calibration output value; and
Vmeas3 is the third calibration output value.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

## Brief Description of the Drawings

One or more embodiments will now be described by way of example only with reference to the accompanying drawings in which:

Figure 1 shows a battery management system (BMS) that will be used to introduce the concept of measurement errors;
Figure 2 shows an example embodiment of a BMS according to the present disclosure;
Figure 3 shows another example embodiment of a BMS according to the present disclosure;
Figure 4 shows a further example embodiment of a BMS according to the present disclosure;
Figure 5 will be used to describe a subsequent step in the calibration routine for a BMS according to the present disclosure; and
Figures 6a and 6b show simulation results that illustrate advantages of the BMSs of the present disclosure.

## Detailed Description

While battery chemistry is getting better and better, the voltage drop between a fully charged cell and an empty cell is getting smaller. Moreover, for lifetime and safety reasons, battery cells need to be protected from undercharging and overcharging. Therefore, a huge pressure is put on the accuracy of a Battery Management Systems (BMS), so that the autonomy of the system can be maximized while keeping the application safe.

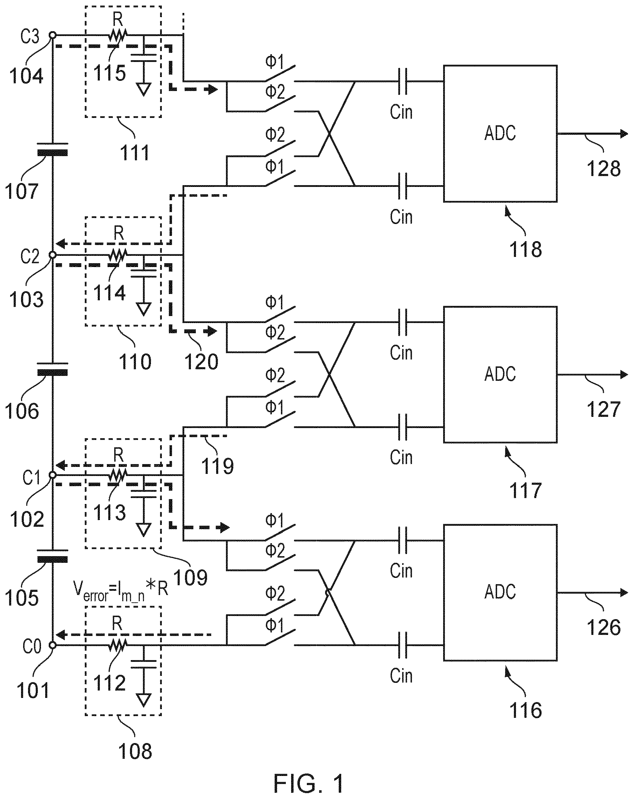

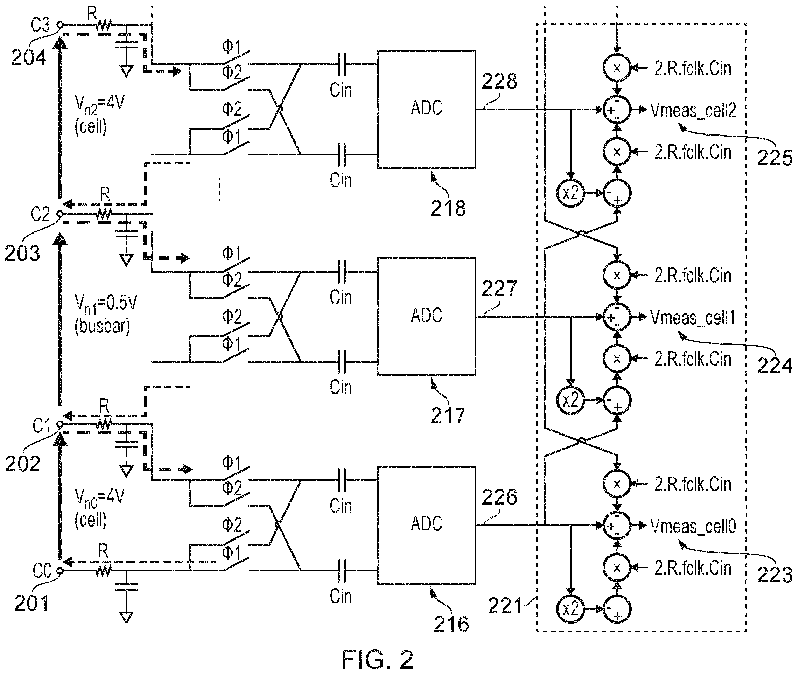

Figure 1 shows a BMS that will be used to introduce the concept of measurement errors, which can be reduced by the examples of the present disclosure that are illustrated in Figures 2 to 5.

The BMS of Figure 1 has a sequence of four battery connection terminals: a first battery connection terminal, C0, 101; a second battery connection terminal, C1, 102; a third battery connection terminal, C2, 103; and a fourth battery connection terminal, C3, 104. The battery connection terminals 101-104 are for connecting to a series / string of batteries 105-107 such that each battery is connected between a different pair of the battery connection terminals. Three batteries 105-107 are shown in Figure 1: a first battery 105 that is connected between the first battery connection terminal, C0, 101 and the second battery connection terminal, C1, 102; a second battery 106 that is connected between the second battery connection terminal, C1, 102 and the third battery connection terminal, C2, 103; and a third battery 107 that is connected between the third battery connection terminal, C2, 103 and the fourth battery connection terminal, C3, 104. In this way, the first battery connection terminal, C0, 101 is for connecting to a terminal of a battery 105 at one end of the series of batteries. A last battery connection terminal, C3, 104 is for connecting to a terminal of a battery 107 at the other end of the series of batteries. Each other battery connection terminal, C1, C2, 102, 103 is for connecting to a node in between two of the batteries 105-107 in the series / string.

It will be appreciated that, in other examples, the BMS can have any number of battery connection terminals for connecting to any appropriate number of batteries.

Also shown in Figure 1 is a low-pass filter 108-111 that is associated with each battery connection terminal 101-104. The low-pass filters 108-111 each include a resistance 112-115 that is connected in series between a respective one of the battery connection terminals 101-104 and an ADC input terminal (as will be discussed below). In addition to, or instead of, the resistances 112-115 of the low-pass filters 108-111 that are shown in Figure 1, the BMS may include a cell-balancing resistance (not shown) between each battery connection terminal 101-104 and an ADC input terminal. Furthermore, a low-pass filter with a different topology could be used instead of the one that is shown in Figure 1; e.g., with capacitors connected to the IC terminal of previous cell instead of being connected to ground. Irrespective of the circuit layout, as we will discuss below, it is the presence of resistances 112-115 the battery connection terminals 101-104 and the ADC input terminals that can result in an inaccuracy with which the voltage levels of the batteries 105-17 can be measured by the BMS.

Figure 1 also shows a sequence of three analogue-to-digital converters (ADCs) 116-118, each associated with a pair of the battery connection terminals. In this way, each ADC 116-118 is for measuring the voltage level of a battery 105-107 that is connected between a pair of the battery connection terminals. In this example: a first ADC 116 is for measuring the voltage level of the first battery 105; a second ADC 117 is for measuring the voltage level of the second battery 106; and a third ADC 118 is for measuring the voltage level of the third battery 107.

Each ADC 116-118 has a first ADC input terminal, a second ADC input terminal and an ADC output terminal. The first ADC input terminal is connected to one of the pair of battery connection terminals via its associated resistance. The second ADC input terminal is connected to the other of the pair of battery connection terminals via its associated resistance. Each ADC 116-118 is configured to convert the difference between the analogue voltages at its first and the second ADC input terminals (i.e., a differential voltage) to a digital signal 126-128, and to provide that digital signal 126-128 at its ADC output terminal.

With reference to the first ADC 116, it's first ADC input terminal is connected to the first battery connection terminal, C0, 101 via the resistance 112 of the low-pass filter 108 associated with first battery connection terminal, C0, 101. The second ADC input terminal of the first ADC 116 is connected to the second battery connection terminal, C1, 102 via the resistance 113 of the low-pass filter 109 associated with second battery connection terminal, C1, 102. Therefore, the first battery connection terminal, C0, 101 and the second battery connection terminal, C1, 102 is the pair of battery connection terminals to which the first ADC 116 is connected. Each of the second and third ADCs 117, 118 are similarly connected to different pairs of battery connection terminals as shown in the figure.

Switched capacitor input circuits such as sample & hold circuits or ADC input stages (as shown in Figure 1) create average DC currents when they are directly connected to the input. The average DC currents are shown in Figure 1 in dashed lines 119, 120 and they will be discussed in more detail below.

As an example, for one switched capacitor ADC, this current sampling current is:

$$I_{p\_n} = 2.f_{clk}.C_{in}.(V_{n+1} - V_n)$$

and

$$I_{m\_n} = 2.f_{clk}.C_{in}.(V_n - V_{n+1}).$$

The $I_{p\_n}$ currents are shown in Figure 1 as dashed lines 120. The $I_{m\_n}$ currents are shown in Figure 1 as dotted lines 119. $V_n$ is the voltage at one of the battery connection terminals to which the ADC is connected. $V_{n+1}$ is the voltage at the other of the battery connection terminals to which the ADC is connected. Therefore, the difference between $V_{n+1}$ and $V_n$ is a differential voltage that is presented across the two input terminals of an ADC 116-118.

If all differential voltages ($V_{n+1}$ - $V_n$) are very similar, then most of the time the current sampling currents $I_{p\_n}$ 120 and $I_{m\_n}$ 119 have the same value and opposite sign. Therefore, they cancel each other out.

However, if $V_{n+1}$ and $V_n$ are at very different voltage levels (for example because a battery is bypassed by a busbar or a short in the BMS), the current sampling currents $I_{p\_n}$ 120 and $I_{m\_n}$ 119 will not cancel each other out such that a significative voltage drop is created across the external resistance of the low-pass filter. This voltage drop results in the ADC not being able to accurately measure the voltage of a battery that is connected to the low-pass filter. A similar issue arises for the ADCs that are connected to the first and the last battery connection terminals because those battery connection terminals only receive one of the current sampling currents $I_{p\_n}$ 120 and $I_{m\_n}$ 119. In Figure 1, the first battery connection terminal, C0, 101 only receives the negative current sampling current $I_{m\_n}$ 119. Therefore, a voltage of $V_{error}=I_{m\_n}*R$ is dropped across the resistance 112 associated with the first battery connection terminal, C0, 101. This voltage is considered as an error voltage because, in terms of what is provided to the first input terminal of the first ADC 116 for measuring, it is effectively subtracted from the voltage of the first battery 105. Similarly, the last battery connection terminal, C3, 104 only receives the positive current sampling current $I_{p\_n}$ 120 such that voltage of $V_{error}=I_{p\_n}*R$ is dropped across the resistance 112 associated with the last battery connection terminal, C3, 104.

The lower the input impedance of an analog front end of a BMS, the larger the differential current at the measurement input. As a consequence, the larger the measurement error due to any external resistances (such as the resistances 112-115 of the low-pass filters 108-111 in Figure 1) associated with the BMS. As indicated above, such external resistances may be present as part of an anti-aliasing filter, as a cell balancing resistor, etc..

It has been found that at least some of the measurement current is predictable, and in many applications the majority of this measurement error is predictable, and therefore can be compensated by digital processing. At least some of the examples described herein relate to a BMS that achieves a reduction in measurement error, which can be implemented on the same integrated circuit as the BMS, with an associated calibration method. This can achieve sub-500µV accuracy in all anticipated application use cases (with a realistic number of battery cells, some of which may be bypassed with a busbar). For instance, examples of the present disclosure use a digital signal processor to mathematically compensate for the error voltages that are dropped across the external resistances. As will be described below, such a digital signal processor can use the values of ($V_{n+1} - V_n$) that are provided at the output terminals of the ADCs 116-18 and also in some examples a value for $2.f_{clk}.C_{in}$ that can be determined by ATE (automatic test equipment) calibration. Where $C_{in}$ is the capacitance of a capacitor at each input terminal of each of the ADC and $f_{clk}$ is the frequency of a clock associated with each ADC.

Figure 2 shows an example embodiment of a BMS according to the present disclosure. Features of Figure 2 that are also shown in Figure 1 have been given corresponding reference numbers in the 200 series and will not necessarily be described again here.

The BMS of Figure 2 includes a digital processor 221. The digital processor 221 provides a measured-voltage output signal 223-225 for each of the ADCs 216-218. That is, the digital processor 221 provides:

- a first measured-voltage output signal 223 for the first ADC 216, such that the first measured-voltage output signal 223 represents the voltage of a first battery that is connected between the first and the second battery connection terminals C0, C1, 201, 202;
- a second measured-voltage output signal 224 for the second ADC 217, such that the second measured-voltage output signal 224 represents the voltage of a second battery that is connected between the second and the third battery connection terminals C1, C2, 202, 203;
- a third measured-voltage output signal 225 for the third ADC 218, such that the third measured-voltage output signal 225 represents the voltage of a third battery that is connected between the third and the fourth battery connection terminals C2, C3, 203, 204.

In the example of Figure 2, the first battery is shown as having a voltage of $V_{n0}=4V$ and the third battery is shown as having a voltage of $V_{n2}=4V$. The second battery is shown as being shorted by a busbar such that the differential voltage between the second and the third battery connection terminals C1, C2, 202, 203 is $V_{n1}=0.5V$.

In the same way as Figure 1, the BMS of Figure 2 has ADCs 216-218 that are directly connected to the external low-pass filters. The errors on the low-pass filters (as discussed above with reference to Figure 1) are present in the analog domain but in Figure 2 they are compensated by digital processing in the digital processor 221. Therefore, beneficially, the solution of Figure 2 is easily transferable from one technology to another.

Considering the different battery / cell voltages (busbar or cell configuration or mismatch), the error voltage in the digital signals 226-228 provided by the ADCs 216-218 due to the voltages dropped across the external resistances is dependent on the voltage levels of the adjacent batteries / cells.

$$V_{error} = R.\left(I_{n+1_m} - I_{n_p} + I_{n-1_p} - I_{n_m}\right)$$

$$V_{error} = 2.R.f_{clk}.C_{in}.\left(V_{n+1} + V_{n-1} - 2.V_n\right)$$

Note that for a battery / cell that is at the start or end of series of batteries (that can also be referred to as a stack of cells), the adjacent battery (where no battery is present) is given a value of 0V.

For the example of Figure 1,

- the error for the first digital signal 226 provided at the output terminal of the first ADC 216 is: $V_{error} = 2. R. f_{clk}. C_{in}.(0.5 + 0 - 2 \times 4)$
- the error for the second digital signal 227 provided at the output terminal of the second ADC 217 is: $V_{error} = 2. R. f_{clk}. C_{in}.(4 + 4 - 2 \times 0.5)$

The magnitude of these errors, due to the different voltage levels of the adjacent batteries / cells, is significant. However, in Figure 2 the digital processor 221 calculates the value for $V_{error}$ for each ADC 216-218 such that it can then be applied to the respective digital signals 226-228 in order to provide accurate measured-voltage output signals 223-225.

For each ADC 216-218, the digital processor 221 calculates an error voltage ($V_{error}$) for the ADC based on: i) the digital signal for the immediately preceding ADC in the sequence, if there is one; and ii) the digital signal for the immediately next ADC in the sequence if there is one. The digital processor 221 then provides the measured-voltage output signals 223-225 by subtracting the error voltage from the digital signal 226-228 for the respective ADC. By way of example, for the second ADC 217 the digital processor 221 calculates the error voltage ($V_{error}$) based on: i) the digital signal 226 for the first ADC 216 in the sequence; and ii) the digital signal 228 for the third ADC 218 in the sequence.

Furthermore, in the implementation of Figure 2, the digital processor 221 calculates the error voltage ($V_{error}$) for each ADC also based on: iii) the digital signal for the ADC. So, for the second ADC 217 the digital processor 221 calculates the error voltage ($V_{error}$) also based on: iii) the digital signal 227 for the second ADC 217 in the sequence. This corresponds to the equation for $V_{error}$ above, which includes $V_n$, $V_{n-1}$ and $V_{n+1}$.

More particularly, in Figure 2 the digital processor 221 calculates the error voltage, $V_{error}$, for each of the n ADCs by applying the following formula:

$$error\ voltage = K\ x\ (V_{n+1} + V_{n-1} - 2.V_n)$$

where:

$K$ is a timing value, which will be described below;
$V_{n+1}$ is the value of the digital signal for the next ADC in the sequence, if there is one;
$V_{n-1}$ is the value of the digital signal for the preceding ADC in the sequence, if there is one; and
$V_n$ is the value of the digital signal for the ADC.

The combination of addition and multiplication blocks that are shown in the digital processor 221 of Figure 2 represents one example of how this formula can be implemented, with $K = 2.R.f_{clk}.C_{in}$.

In some examples, this formula may only be applied for intermediate ADCs in the sequence; that is, all ADCs that are not either the first or the last ADC in the sequence. This is because the first and the last ADCs do not have either a preceding or a next ADC in the sequence. Therefore, it has been found that using a slightly different formula for the first and last ADCs can further improve the accuracy of the measured-voltage output signals 223, 225 for those ADCs.

More particularly, for the first ADC 216 in the sequence, the digital processor 221 can calculate the error voltage, $V_{error}$, by applying the following formula:

$$error\ voltage = K\ x\ (V_{n+1} - V_n)$$

where:

$K$ is the timing value;
$V_{n+1}$ is the value of the digital signal 227 for the second ADC 217 in the sequence; and
$V_n$ is the value of the digital signal 226 for the ADC.

Also, for the last ADC 218 in the sequence, the digital processor 221 can calculate the error voltage, $V_{error}$, by applying the following formula:

$$error\ voltage = K\ x\ (V_{n-1} - V_n)$$

where:

$K$ is a timing value;
$V_{n-1}$ is the value of the digital signal 227 for the penultimate ADC 217 in the sequence; and
$V_n$ is the value of the digital signal 228 for the ADC 218.

For the circuit layout of Figure 2, the timing value, $K$, takes the following value: $K = 2.R.f_{clk}.C_{in}$. Where:

$R$ is the resistance value of the resistance associated with each battery connection terminal;
$C_{in}$ is the capacitance of a capacitor at each input terminal of each of the ADC; and
$f_{clk}$ is the frequency of a clock associated with each ADC.

However, it will be appreciated that for other circuit layouts the timing value, $K$, may be implemented differently.

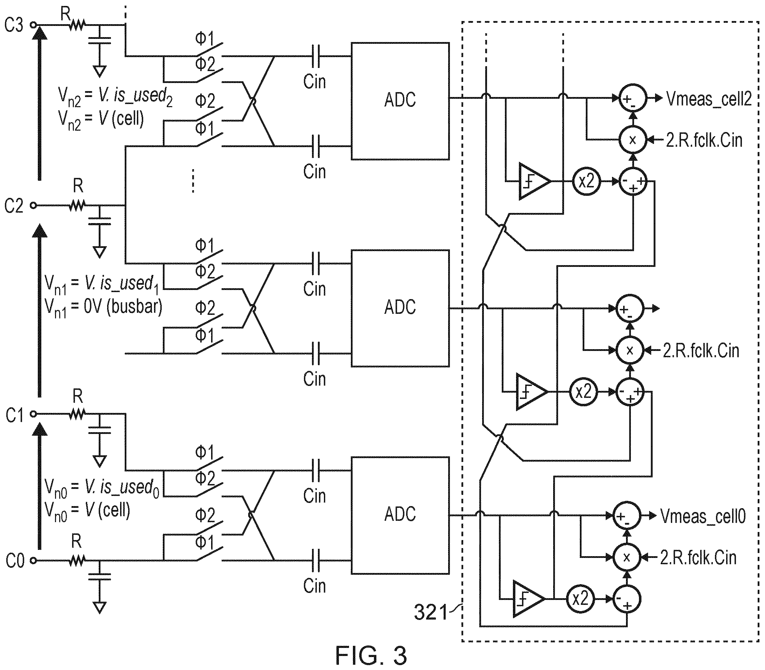

Figure 3 shows another example embodiment of a BMS according to the present disclosure.

The BMS of Figure 2 is accurate but may require a considerable die size in digital processing, depending on the technology used. In many BMS use cases, all cell voltages will be either equal, or close to 0V (when shorted by busbar or if it is a non-used cell). A fair simplification can be made by detecting non-used cells or busbars by comparing the measurement voltage with a threshold value. For example, if a battery / cell voltage is lower than 1V, then that battery / cell is considered as not being used or being shorted by a busbar.

Using this simplification, we can introduce a binary variable called *is_used*. Then, we can write:

$$V_{error} = 2.R.f_{clk}.C_{in}.(V.is\_used_{n+1} + V.is\_used_{n-1} - 2.V.is\_used_n)$$

$$V_{error} = 2.R.f_{clk}.C_{in}.V.(is\_used_{n+1} + is\_used_{n-1} - 2.is\_used_n)$$

Where $V$ is the expected voltage value of a battery / cell that is connected to the BMS.

These equations are implemented by the digital processor 321 that is shown in Figure 3.

Beneficially, the implementation of the digital processor 321 of Figure 3 uses fewer multipliers than the digital processor that is shown in Figure 2. In Figure 3, the multiplication by term $2.R.f_{clk}.C_{in}.V$ can be centralized and ($is\_used_{n+1}$ + $is\_used_{n-1}$ - $2.is\_used_n$) is a sum of 3 binary variables. The possible values are -2, -1, 0, 1 or 2. Therefore the digital implementation of Figure 3 is easier and more compact than the implementation of Figure 2.

In this way, the digital processor 321 calculates the error voltage, $V_{error}$, for the ADCs in the sequence, by:

• comparing the digital signal for the preceding ADC in the sequence, if there is one, with a threshold value in order to generate a preceding-ADC-in-use-signal. This preceding-ADC-in-use-signal corresponds to the $is\_used_{n-1}$ variable that is described above, and has a binary value of '1' if the digital signal is higher than the threshold and a binary value of '0' if it is less than the threshold;

• comparing the digital signal for the next ADC in the sequence, if there is one, with a threshold value in order to generate a next-ADC-in-use-signal. that has a binary value. This next-ADC-in-use-signal corresponds to the $is\_used_{n+1}$ variable that is described above, and has a binary value of '1' if the digital signal is higher than the threshold and a binary value of '0' if it is less than the threshold;

• combining the preceding-ADC-in-use-signal and the next-ADC-in-use-signal in order to determine an error-multiplier. This combination can be a sum of the binary variables, as discussed above, which represents the magnitude of the expected error in the digital signal for the ADC that is being considered; and

• multiplying the error-multiplier by a predetermined voltage value. This predetermined voltage value corresponds to the expected voltage value of a battery that is connected to the BMS, $V$, as discussed above.

in order to fully implement the equation for $V_{error}$ that is indicated above, the digital processor in this example calculates the error voltage, $V_{error}$, for each ADC by also: comparing the digital signal for the ADC with a threshold value in order to generate an ADC-in-use-signal. This ADC-in-use-signal corresponds to the $is\_used_n$ variable that is described above, and again has a binary value of '1' if the digital signal is higher than the threshold and a binary value of '0' if it is less than the threshold.

The digital processor can then combine the preceding-ADC-in-use-signal, the next-ADC-in-use-error-signal and the ADC-in-use-signal in order to determine the error-multiplier in the same way that is described above.

In a similar way to that described with reference to Figure 2, the digital processor 321 of Figure 3 can apply a different equation for the first and last ADCs, when compared with the equation that is applied for the intermediate ADCs. In this way, a different equation is applied to compensate the measurement current for the first and last batteries because they already have a partial measurement current compensation in their gain compensation:

$$V_{error} = 2.R.f_{clk}.C_{in}.(V_{n+1} + V_{n-1} - 1.V_n)$$

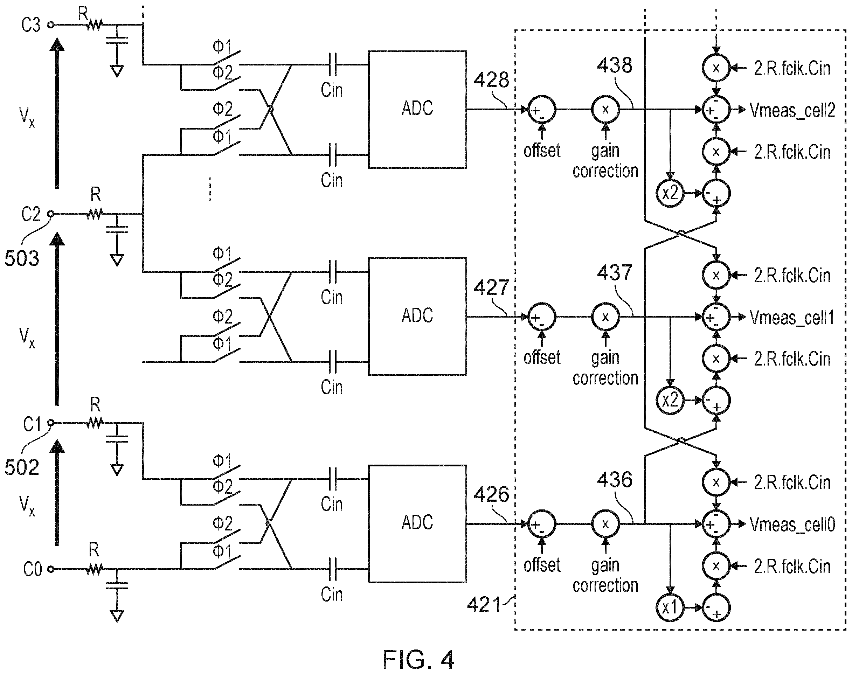

With $V_{(n+1)}$=0 for the last / top battery, and $V_{(n-1)}$=0 for the first / bottom battery. This is shown in Figure 4 for the first ADC in the sequence.

Therefore, for the first and last ADC in the sequence, the digital processor 321:

combines the preceding-ADC-in-use-signal ($is\_used_{n-1}$), the next-ADC-in-use-error-signal ($is\_used_{n+1}$) and the ADC-in-use-signal ($is\_used_n$) in order to determine the error-multiplier according to the following equation:

error-multiplier = preceding-ADC-in-use-signal + next-ADC-in-use-error-signal – ADC-in-use-signal.

Whereas, for each intermediate ADC, the digital processor 321:

combines the preceding-ADC-in-use-signal ($is\_used_{n-1}$), the next-ADC-in-use-error-signal ($is\_used_{n+1}$) and the ADC-in-use-signal ($is\_used_n$) in order to determine the error-multiplier according to the following equation:

error-multiplier = preceding-ADC-in-use-signal + next-ADC-in-use-error-signal – 2 x ADC-in-use-signal.

Once the digital processor 321 has calculated the error-multiplier for an ADC, it can calculate the error voltage for the ADC by multiplying the error-multiplier and the predetermined voltage value ($V$) by a timing value, $K$, wherein:

$$K = 2.R.f_{clk}.C_{in};$$

$R$ is the resistance value of the resistance associated with each battery connection terminal;
$C_{in}$ is the capacitance of a capacitor at each input terminal of each of the ADC; and
$f_{clk}$ is the frequency of a clock associated with each ADC.

Irrespective of whether the full digital correction of Figure 2 or the simplified digital correction of Figure 3 is implemented, the term $2.R.f_{clk}.C_{in}$ needs to be evaluated for those examples. $R$ is the external resistance which can be specified in an associated datasheet. Its variation is usually modest; e.g., 1% initially (at t0), and 4% over lifetime. Whereas, $f_{clk}$ and $C_{in}$ can vary a lot over process and temperature corners: $\pm 25\%$ or even more. However, mismatch from channel to channel is relatively negligible for R and $C_{in}$ and therefore we can assume that $f_{clk}$ is the same for all channels in the BMS. In this way, we will assume that $2.R.f_{clk}.C_{in}$ is the same for all channels of the BMS chip.

Figure 4 shows a further example embodiment of a BMS according to the present disclosure. In Figure 4, the digital processor 421 further mitigates for a gain error $\gamma\_channel$ and an offset error $o\_channel$ associated with the ADCs.

As will be discussed below, values for the gain error $\gamma\_channel$ and the offset error $o\_channel$ can be determined as part of a calibration routine.

In Figure 4, the digital processor 421 applies a gain-correction voltage and an offset-correction voltage to each digital signal 426-428 of the sequence of ADCs to provide a respective plurality of corrected digital signals 436-438. Then, as shown in Figure 4, the digital processor 421 performs all subsequent processing (including the processing that is described with reference to Figures 2 and 3) on the corrected digital signals 436-438 instead of the digital signals 426-428. In this example, the digital processor 421 multiplies each digital signal 426-428 by the gain-correction voltage, and it subtracts the offset-correction voltage from each digital signal 426-428.

We will now turn to the calibration routine that is performed by or on the BMS to determine the values for the gain-correction voltage and the offset-correction voltage. The calibration routine can be performed as an ATE calibration strategy.

As a first step, the calibration routine involves setting the voltage difference between each successive pair of battery connection terminals in the sequence to a first calibration value, and then recording the measured-voltage output signal for each ADC as a first calibration output value. In this way, all channels are forced at the same voltage. The measurement current error should be zero because all measurement currents should be compensating for each other except for the first and last ADCs (which can also be referred to as the top and bottom channels). For the intermediate ADCs / channels we have:

$$V_{meas1} = \gamma_{channel}.V_{X1} + o_{channel}$$

Where:

$V_{meas1}$ is the first calibration output value; and
$V_{X1}$ is the first calibration value.

Then, as a second step, the calibration routine involves setting the voltage difference between each successive pair of battery connection terminals in the sequence to a second calibration input value, and recording the measured-voltage output signal for each ADC as a second calibration output value. in this way, all channels are forced at the same voltage but one that is different to the first calibration value. For the intermediate ADCs / channels we now have:

$$V_{meas2} = \gamma_{channel}.V_{X2} + o_{channel}$$

Where:

$V_{meas2}$ is the second calibration output value; and
$V_{X2}$ is the second calibration value

The BMS can now determine the values for the gain-correction voltage and the offset-correction voltage for each ADC based on: the first calibration value, the second calibration value, the first calibration output value associated with the ADC, and the second calibration output value associated with the ADC. For instance, these values can be determined by solving the above two equations as simultaneous equations for each ADC. That is:

$$\gamma_{channel} = \frac{V_{meas2} - V_{meas1}}{V_{X2} - V_{X1}} \ ;$$

and

$$o_{channel} = \frac{V_{X2}.V_{meas1} - V_{X1}.V_{meas2}}{V_{X2} - V_{X1}}$$

However, for the first and last ADCs (the top and bottom channels):

$$V_{meas1} = \gamma_{channel}.V_{X1} + o_{channel} - 2.R.f_{clk}.C_{in}.V_{X1}$$

$$V_{meas2} = \gamma_{channel}.V_{X2} + o_{channel} - 2.R.f_{clk}.C_{in}.V_{X2}$$

Therefore:

$$\gamma_{channel} + 2.R.f_{clk}.C_{in} = \frac{V_{meas2} - V_{meas1}}{V_{X2} - V_{X1}} \ ;$$

and

$$o_{channel} = \frac{V_{X2}.V_{meas1} - V_{X1}.V_{meas2}}{V_{X2} - V_{X1}}$$

The gain is undercompensated for the top and the bottom channels.

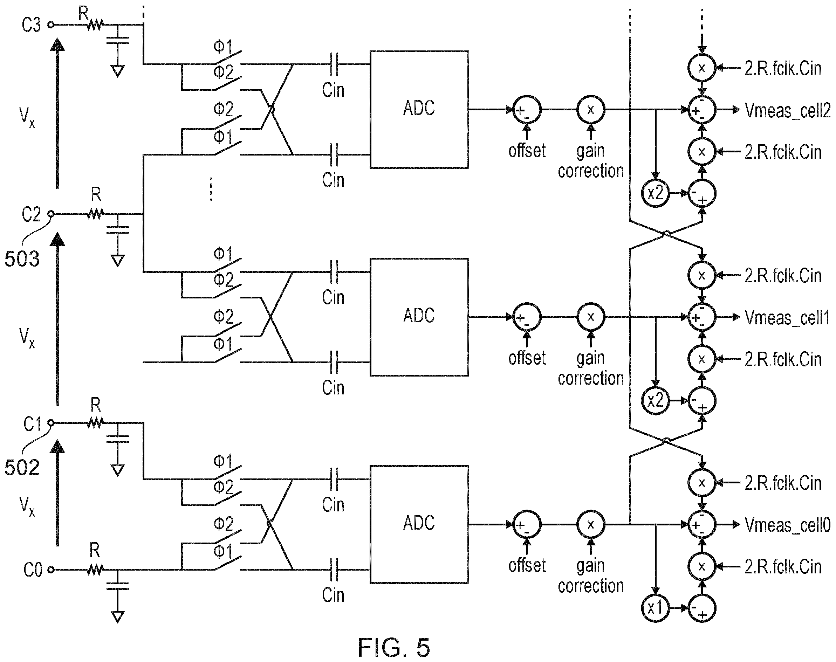

Turning now to Figure 5, we will describe a subsequent step in the calibration routine for determining the value for the timing value, $K$. In the above examples, the timing value, $K$, is $2.R.f_{clk}.C_{in}$. This subsequent step assumes that $2.R.f_{clk}.C_{in}$ is the same for all channels.

As shown in Figure 5, the BMS sets the voltage difference between an intermediate pair of battery connection terminals in the sequence to zero; in this example the intermediate pair of battery connection terminals are the second and the third battery connection terminals C1, C2, 502, 503. At the same time, the BMS sets the voltage difference between the adjacent pairs of battery connection terminals in the sequence to the first calibration value. Therefore, all $V_x$ are equal except on one battery: for this battery we see the current measurement impact.

The measured-voltage output signal for the ADC associated with the intermediate pair of battery connection terminals is then recorded as a third calibration output value, $V_{meas3}$. In this way, one cell in the middle of the stack is forced to 0V while the others are at $V_{X1}$. For this specific cell we have:

$$V_{meas3} = O_{channel} - V_{error}$$

$$V_{error} = 2.R.f_{clk}.C_{in}.(V_{n+1} + V_{n-1} - 2.V_n) = 4.R.f_{clk}.C_{in}.V_{X1}$$

$$2.R.f_{clk}.C_{in} = \frac{O_{channel} - V_{meas3}}{2.V_{X1}}$$

$$2.R.f_{clk}.C_{in} = \frac{V_{X2}.V_{meas1} - V_{X1}.V_{meas2} - (V_{X2} - V_{X1}).V_{meas3}}{2.V_{X1}.(V_{X2} - V_{X1})}$$

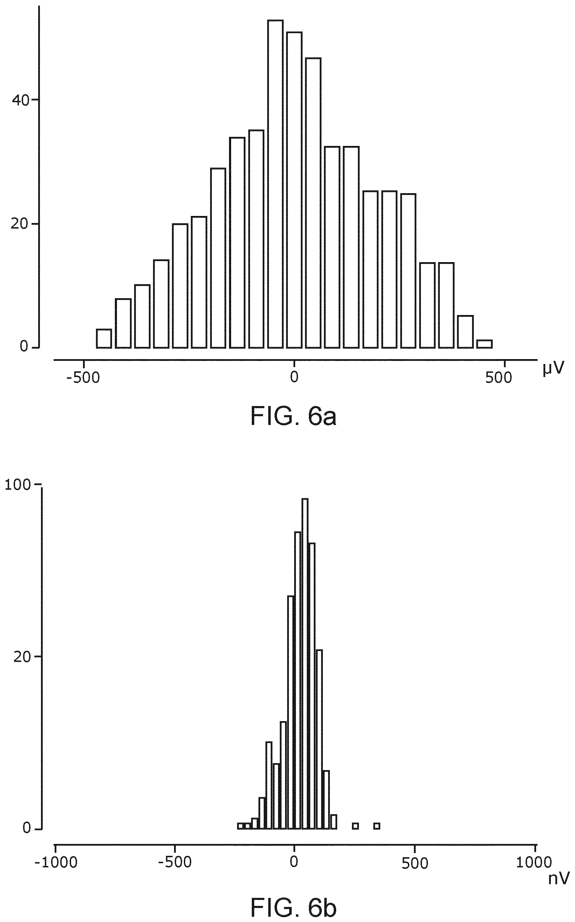

Figures 6a and 6b show simulation results that illustrate advantages of the BMSs of the present disclosure. In the simulations, random cell voltages were used, artificial gain errors and offsets were added to an ideal ADC, and 500 sample measurements were taken. Measurement error for each cell is shown on the horizontal axis (in microvolts in Figure 6a and in nanovolts in Figure 6b). Number of samples is shown on the vertical axis.

Figure 6a shows the simulation results for the BMS of Figure 1; that is, one without a digital processor to perform error correction. Figure 6b shows the simulation results for the BMS of Figure 4; that is, one that includes a digital processor to perform gain and offset calibration as well as mathematical compensation of the measurement current error.

In Figure 6a, the standard deviation is 320μV. In Figure 6b, the standard deviation is 115nV. Therefore, Figures 6a and 6b show that the use of the digital processor of Figure 4 greatly increases the accuracy of the measurements of the cell voltages.

One or more of the examples disclosed herein can compensate for analog imperfection in the digital domain. This is in contrast to performing compensation in the analog domain using, for example, pre-charge circuits or buffers. Advantageously, performing the compensation in the digital domain results in a lower current consumption, smaller die size, and is perfectly scalable from one technology to another. Furthermore, it can reduce / minimize compensation imperfections and risks of drift.

Any voltage shift created by a sampling current on any input resistors can be compensated by digital processing, even if the cell voltages are different (in the case of a busbar, for example). A simplified compensation method is also described that simplifies digital implementation and further reduces die-size. Finally, a calibration method that can be performed by Automated Tester Equipment (ATE) is also described.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

**Claims**

1. A battery management system comprising:

   a sequence of four or more battery connection terminals for connecting to a series of batteries such that each battery is connected between a pair of the battery connection terminals, wherein:

   a first battery connection terminal is for connecting to a terminal of a battery at one end of the series of batteries;
   a last battery connection terminal is for connecting to a terminal of a battery at the other end of the series of batteries; and
   each other battery connection terminal is for connecting to a node in between two of the batteries in the series;

   a resistance associated with each battery connection terminal;
   a sequence of three or more ADCs, each associated with a pair of the battery connection terminals, each ADC having:

   a first ADC input terminal, which is connected to one of the pair of battery connection terminals via its associated resistance;
   a second ADC input terminal, which is connected to the other of the pair of battery connection terminals via its associated resistance; and
   an ADC output terminal;

   wherein:

   each ADC is configured to convert the difference between the analogue voltages at its first and the second ADC input terminals to a digital signal, and to provide that digital signal at its ADC output terminal; and

   a digital processor configured to, for each ADC in the sequence:

   calculate an error voltage for the ADC based on: i) the digital signal for the preceding ADC in the sequence if there is one; and ii) the digital signal for the next ADC in the sequence if there is one; and
   provide a measured-voltage output signal by subtracting the error voltage from the digital signal for the ADC.

2. The battery management system of claim 1, wherein the digital processor is further configured to, for each ADC in the sequence, calculate the error voltage also based on: iii) the digital signal for the ADC.

3. The battery management system of claim 1 or claim 2, wherein the digital processor is configured to, for each intermediate ADC in the sequence, calculate the error voltage by applying the following formula:

$$\text{error voltage} = K \times (V_{n+1} + V_{n-1} - 2.V_n)$$

where:

K is a timing value;
$V_{n+1}$ is the value of the digital signal for the next ADC in the sequence, if there is one;
$V_{n-1}$ is the value of the digital signal for the preceding ADC in the sequence, if there is one; and
$V_n$ is the value of the digital signal for the ADC.

4. The battery management system of any preceding claim, wherein the digital processor is configured to, for the first ADC in the sequence, calculate the error voltage by applying the following formula:

$$\text{error voltage} = K \times (V_{n+1} - V_n)$$

where:

K is a timing value;
$V_{n+1}$ is the value of the digital signal for the next ADC in the sequence;
and
$V_n$ is the value of the digital signal for the first ADC.

5. The battery management system of any preceding claim, wherein the digital processor is configured to, for the last ADC in the sequence, calculate the error voltage by applying the following formula:

$$\text{error voltage} = K \times (V_{n-1} - V_n)$$

where:

K is a timing value;
$V_{n-1}$ is the value of the digital signal for the preceding ADC in the sequence; and
$V_n$ is the value of the digital signal for the last ADC.

6. The battery management system of any one of claims 3 to 5, wherein:

$$K = 2.R.f_{clk}.C_{in};$$

R is the resistance value of the resistance associated with each battery connection terminal;
$C_{in}$ is the capacitance of a capacitor at each input terminal of each of the ADC; and
$f_{clk}$ is the frequency of a clock associated with each ADC.

7. The battery management system of any preceding claim, wherein the digital processor is configured to, for each ADC in the sequence, calculate the error voltage for the ADC by:

comparing the digital signal for the preceding ADC in the sequence, if there is one, with a threshold value in order to generate a preceding-ADC-in-use-signal;
comparing the digital signal for the next ADC in the sequence, if there is one, with a threshold value in order to generate a next-ADC-in-use-signal;
combining the preceding-ADC-in-use-signal and the next-ADC-in-use-signal in order to determine an error-multiplier; and
multiplying the error-multiplier by a predetermined voltage value.

8. The battery management system of claim 7, wherein the digital processor is further configured to, for each ADC in the sequence, calculate the error voltage for the ADC by:

> comparing the digital signal for the ADC with a threshold value in order to generate an ADC-in-use-signal; and
> combining the preceding-ADC-in-use-signal, the next-ADC-in-use-error-signal and the ADC-in-use-signal in order to determine the error-multiplier.

9. The battery management system of claim 8, wherein the digital processor is further configured to, for each intermediate ADC:
combine the preceding-ADC-in-use-signal, the next-ADC-in-use-error-signal and the ADC-in-use-signal in order to determine the error-multiplier according to the following equation:

$$\text{error-multiplier} = \text{preceding-ADC-in-use-signal} + \text{next-ADC-in-use-error-signal} - 2 \times \text{ADC-in-use-signal}.$$

10. The battery management system of claim 9, wherein the digital processor is further configured to, for the first and last ADC in the sequence:
combine the preceding-ADC-in-use-signal, the next-ADC-in-use-error-signal and the ADC-in-use-signal in order to determine the error-multiplier according to the following equation:

$$\text{error-multiplier} = \text{preceding-ADC-in-use-signal} + \text{next-ADC-in-use-error-signal} - \text{ADC-in-use-signal}.$$

11. The battery management system of any one of claims 7 to 10, wherein the digital processor is further configured to, for each ADC in the sequence, calculate the error voltage for the ADC by multiplying the error-multiplier and the predetermined voltage value by a timing value, K, wherein:

$$K = 2.R.f_{clk}.C_{in};$$

> R is the resistance value of the resistance associated with each battery connection terminal;
> $C_{in}$ is the capacitance of a capacitor at each input terminal of each of the ADC; and
> $f_{clk}$ is the frequency of a clock associated with each ADC.

12. The battery management system of any preceding claim, wherein the digital processor is further configured to:

> apply a gain-correction voltage and / or an offset-correction voltage to each digital signal of the sequence of ADCs to provide a respective plurality of corrected digital signals; and
> perform all subsequent processing on the corrected digital signals instead of the digital signals.

13. The battery management system of claim 12, wherein the battery management system is configured to perform a calibration routine to determine the values for the gain-correction voltage and / or the offset-correction voltage.

14. The battery management system of claim 13, configured to perform the calibration routine by:

> setting the voltage difference between each successive pair of battery connection terminals in the sequence to a first calibration value, and recording the measured-voltage output signal for each ADC as a first calibration output value;
> setting the voltage difference between each successive pair of battery connection terminals in the sequence to a second calibration input value, and recording the measured-voltage output signal for each ADC as a second calibration output value; and
> determining the values for the gain-correction voltage and / or the offset-correction voltage for each ADC based on: the first calibration value, the second calibration value, the first calibration output value associated with the ADC, and the second calibration output value associated with the ADC.

15. The battery management system of claim 14 when it depends directly or indirectly from any one claims 3, 4, 9, 11, configured to perform the calibration routine by determining the value for the timing value, K, by:

setting the voltage difference between each successive pair of battery connection terminals in the sequence to a first calibration value, and recording the measured-voltage output signal for each ADC as a first calibration output value;

setting the voltage difference between each successive pair of battery connection terminals in the sequence to a second calibration input value, and recording the measured-voltage output signal for each ADC as a second calibration output value;

setting the voltage difference between an intermediate pair of battery connection terminals in the sequence to zero and at the same time setting the voltage difference between the adjacent pairs of battery connection terminals in the sequence to first calibration value, and recording the measured-voltage output signal for the ADC associated with the intermediate pair of battery connection terminals as a third calibration output value; and

determining the values for the gain-correction voltage and the offset-correction voltage using the following equation:

$$K = \frac{V_{X2}.V_{meas1} - V_{X1}.V_{meas2} - (V_{X2} - V_{X1}).V_{meas3}}{2.V_{X1}.(V_{X2} - V_{X1})}$$

wherein:

$V_{X1}$ is the first calibration value;
$V_{X2}$ is the second calibration value;
Vmeas1 is the first calibration output value;
Vmeas2 is the second calibration output value; and
Vmeas3 is the third calibration output value.

FIG. 1

FIG. 2

EP 4 488 698 A1

FIG. 3

FIG. 4

FIG. 5

FIG. 6a

FIG. 6b

Europäisches
Patentamt

European
Patent Office

Office européen
des brevets

# EUROPEAN SEARCH REPORT

Application Number

**EP 23 30 6162**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/181658 A1 (KITAGAWA MASAAKI [JP] ET AL) 13 June 2019 (2019-06-13) | 1-5,7-10 | INV. G01R31/3835 |
| Y | * the whole document * | 6,11-15 | G01R31/396 G01R35/00 |
| Y | US 2021/278474 A1 (RAVINUTHULA VISHNU [US] ET AL) 9 September 2021 (2021-09-09) * the whole document * | 12-15 | |
| Y | US 2007/182377 A1 (VANDENSANDE GEERT [BE]) 9 August 2007 (2007-08-09) * the whole document * | 6,11-15 | |
| Y | US 2021/151834 A1 (ASHRAFZADEH AHMAD [US]) 20 May 2021 (2021-05-20) * the whole document * | 12-15 | |

TECHNICAL FIELDS
SEARCHED (IPC)

**G01R**

The present search report has been drawn up for all claims

| Place of search | Date of completion of the search | Examiner |
|---|---|---|
| Munich | 20 December 2023 | Ardelt, Per-Lennart |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 30 6162

This annex lists the patent family members relating to the patent documents cited in the above-mentioned European search report.
The members are as contained in the European Patent Office EDP file on
The European Patent Office is in no way liable for these particulars which are merely given for the purpose of information.

20-12-2023

| Patent document cited in search report | | | Publication date | Patent family member(s) | | | Publication date |
|---|---|---|---|---|---|---|---|
| US 2019181658 | A1 | | 13-06-2019 | CN | 109904905 | A | 18-06-2019 |
| | | | | DE | 102018131407 | A1 | 13-06-2019 |
| | | | | JP | 7056113 | B2 | 19-04-2022 |
| | | | | JP | 2019105453 | A | 27-06-2019 |
| | | | | US | 2019181658 | A1 | 13-06-2019 |
| US 2021278474 | A1 | | 09-09-2021 | NONE | | | |
| US 2007182377 | A1 | | 09-08-2007 | EP | 1806592 | A1 | 11-07-2007 |
| | | | | US | 2007182377 | A1 | 09-08-2007 |
| US 2021151834 | A1 | | 20-05-2021 | CN | 111344582 | A | 26-06-2020 |
| | | | | EP | 3710841 | A1 | 23-09-2020 |
| | | | | US | 2019148701 | A1 | 16-05-2019 |
| | | | | US | 2021151834 | A1 | 20-05-2021 |
| | | | | WO | 2019099213 | A1 | 23-05-2019 |

EPO FORM P0459

For more details about this annex : see Official Journal of the European Patent Office, No. 12/82